# EUROPEAN PATENT APPLICATION

(11) **EP 2 017 889 A2**
(43) Date of publication of application: **21.01.2009**
(21) Application number: 08157492.3
(22) Date of filing: 03.06.2008
(51) Int. Cl.: H01L 23/498

(54) **Ultra-thick thick film on ceramic substrate**

(30) Priority: 28.06.2007 US 823690
(71) Applicant: Delphi Technologies, Inc., Troy, Michigan 48007 (US)
(72) Inventor: Flederbach, Lynda G., Kokomo, IN 46901 (US); Weed, Rick A., Kokomo, IN 46902 (US); Carter, Bradley H., Kokomo, IN 46902 (US); Gerbsch, Erich W., Cicero, IN 46034 (US); Isenberg, John, K., Rossville, IN 46904 (US); Berlin, Carl W., West Lafayette, IN 47906 (US)
(74) Representative: Denton, Michael John

(57) **Abstract**

An electrically isolated and thermally conductive double-sided prepackaged integrated circuit component exhibiting excellent heat dissipative properties, durability and strength, and which can be manufactured at a low cost includes electrically insulated and thermally conductive substrate members having outer surfaces, ultra-thick thick film materials secured to the outer surfaces of the substrate members and a lead member and a transistor member positioned between the substrate members.

## Description

### Technical Field

This invention relates to circuit board components and more particularly to electrically isolated and thermally conductive pre-packaged components.

### Background of the Invention

There are numerous types of circuit board components in use today, including those which have been specifically developed for high current and high power applications, such as for electrical vehicles. A current component used in these applications is a T0247 package. These devices utilize metalized ceramic substrates, stamped copper leads or lead frames, wire bonds or solderable topside integrated circuits (ICs). There are a variety of solderable topside packages for use with discrete power devices and integrated circuits.

U.S. Patent No. 7,095,098 discloses an improved circuit board component for high power and high current applications, such as an improved TO220-type package. The TO220-type package is one-half the size of the T0247 package. The disclosed device utilizes two ceramic substrates each having a solderable electrically conductive copper material direct bonded to the outer surface of the substrates, with a metal oxide semiconductor field effect transistor (MOSFET) positioned between the substrates (which are electrically non-conductive). Appropriate pads and leads are provided for electrically connecting the gate, drain and source of the MOSFET. An isolated gate bipolar transistor (IGBT) may be used instead of a MOSFET. With the disclosed arrangement, power can be dissipated in two directions from the IC component device, either up through the substrate on the upper surface of the device, or down through the base substrate. Utilization of a double-sided package reduces the temperature rise of the device approximately in half. The disclosed devices have the ability to carry higher currents with less temperature rise than conventional wire bonded and strap bonded devices. While these devices have many advantages, the use of direct-bond copper (DBC) on ceramic substrate technologies to meet thermal and electrical isolation requirements for high current-carrying power electronic devices is relatively expensive.

### Summary of the Invention

The invention provides an improved, lower cost technology for meeting thermal and electrical isolation requirements for high current-carrying power electronic devices. More specifically, high current-carrying power electronic devices are thermally connected and electrically isolated utilizing an ultra-thick thick film (UTTF) on a ceramic substrate. An integrated circuit device is positioned between ceramic substrates having the UTTF film deposited on the inner and outer surfaces of each of the substrates.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 illustrates a packaged component in accordance with the present invention.
FIGS. 2 and 3 are exploded views of the component device shown in FIG. 1, with FIG. 2 showing the exploded view in one direction and FIG. 3 showing the exploded view in the opposite direction.

### Description of the Preferred Embodiments

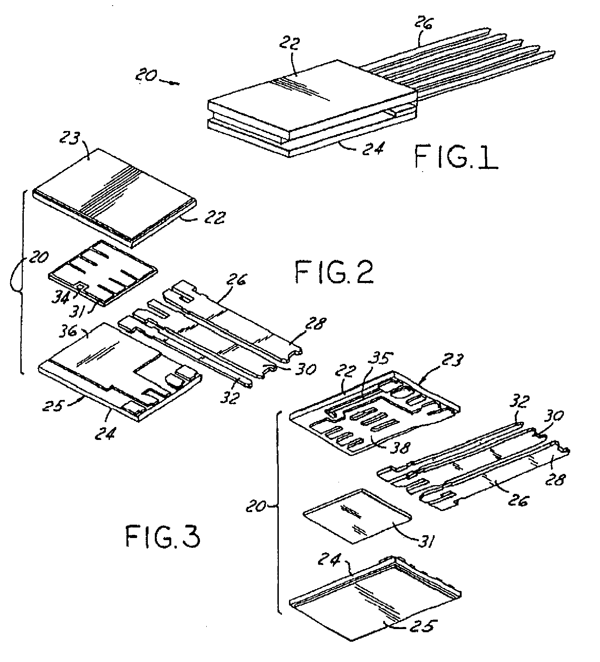

An embodiment of the present invention shown in FIG. 1 and indicated in general by the reference numeral 20. FIGS. 2 and 3 are exploded views of the device 20 showing the components in opposite directions.

Device 20 has a pair of ceramic substrate members 22 and 24. The ceramic material can be any of the ceramic materials commonly used, including alumina (Al₂O₃) and aluminum nitride (A1N). While presently less desirable, it is possible that silicon nitride (SiN) or beryllium oxide (BeO) may be used. These ceramic substrates vary in thermal performance so the selection of the particular ceramic material to be utilized typically depends on the thermal requirements of the specific application.

Device 20 includes a lead frame 26, which typically is comprised of a stamped copper material. The lead frame typically has a plurality of connector members, including a source member 28, a drain member 30, and a gate member 32. The source member 28, drain member 30 and gate member 32 are used to connect device 20 to an electrical bus or other device utilized in a particular application. Lead frames 26 are particularly used in high current applications (e.g., greater than 200 amperes). For lower current applications individual lead pins can be utilized.

Device 20 also includes a transistor, such as a MOSFET (metal oxide semiconductor field effect transistor) or an IGBT (isolated gate bipolar transistor) 31 which is positioned between the two substrates 22 and 24 and electrically connected to the members in lead frame 26.

Drain member 30 is soldered and mechanically connected to the top and bottom substrate members 22 and 24. Drain member 30 is electrically connected to drain pad 36 only. Source member 28 is similarly soldered and mechanically connected to the top and bottom substrate members 22 and 24. Source member 28 is electrically connected to the source pad 38 only. Gate pin or member 32 is soldered to gate runner 35 which is electrically connected to gate 34 of transistor 31.

Each of the ceramic substrates 22 and 24 includes an ultra-thick thick film layer 23 and 25 on the outer surfaces thereof. Ultra-thick thick film materials are described in U.S. Patent No. 5,527,627, which is incorporated by reference herein. In general, ultra-thick thick film(s) as used herein refer to a film having a thickness of from about 25 micrometers to about 125 micrometers. Ultra-thick thick film(s) are generally comprised of about 80 to about 90% by weight of a metal powder (e.g., copper, silver or other conductive material, preferably silver), with the balance of the composition generally comprising a combination of inorganic oxide binders and organic binders.

In accordance with a preferred embodiment of the invention, the ceramic substrates are a thin alumina substrate printed with generally any conventional ultra-thick thick film material. A thin alumina substrate is one having a thickness less than 500 micrometers, and more preferably less than or about 250 micrometers. Using the double-side cooling arrangement (i.e., an ultra-thick thick film coated ceramic substrate on each side of the transistors), it is possible to achieve heat dissipative properties comparable to single-side cooled aluminum nitride (ALN)/DBC substrates using relatively inexpensive alumina/UTTF substrate.

In accordance with another preferred embodiment of the invention, an ultra-thick thick film layer printed on an intermediate buffer layer of thick film conductor on a conventional ceramic substrate is substantially free of metal oxide binders, i.e., the UTTF consists essentially of a conductive metal powder and one or more organic binders. By utilizing an ultra-thick thick film composition that is substantially free of metal oxides (e.g., less than 1% by weight), it is possible to utilize a UTTF coating layer on a highly thermally-conductive substrate such as aluminum nitride, which would otherwise react with metal oxides in the UTTF composition causing the production of gases and blistering of the film during firing (i.e., a process in which an applied UTTF material is converted into a coherent film).

With the present invention, power can be dissipated in two directions from the integrated circuit component device, either up through the substrate on the upper surface of the device, and/or down through the base substrate. Utilization of a double-sided package reduces the temperature rise of the device approximately in half.

By providing electrically isolated top and bottom surfaces, the use of heat sink pads are eliminated. Heat sink pads are expensive to acquire and utilize in a device and also add thermal resistance to the device on the order of 0.1 to 0.5°C./watt.

The invention is not limited to TO220-type devices. It can be used, for example, with devices having larger substrates and "footprints," such as super T0220 devices, T0247 devices and SO devices. The invention also has use in both single inline package devices (SIPs) and dual inline package devices (DIPs).

The present inventive devices have the ability to carry higher currents with less temperature rise than conventional wire bonded and strap bonded devices. The inventive devices conduct current and uniformly extract heat across the entire face, not just at certain wire bond connection sites. Further, the inventive devices utilizing a UTTF layer on a ceramic substrate has substantial cost advantages over arrangements utilizing conductive copper material direct-bonded to the outer surface of the ceramic substrates.

The devices of the invention are also expected to have durability, fatigue strength, manufacturing cycle time and configuration flexibility comparable to similar devices utilizing DBC technology.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A pre-packaged component device comprising:
a first non-conductive substrate member having an outer surface;
a second non-conductive substrate member having an outer surface;
a first layer of ultra-thick thick film material secured to the outer surface of said first non-conductive substrate member;
a second layer of ultra-thick thick film material secured to the outer surface of said second non-conductive substrate member; and
lead members and a transistor member positioned between said first and said second non-conductive substrate members.

2. The device of claim 1, wherein the first and second non-conductive substrate members are made of a ceramic material.

3. The device of claim 2, wherein the ceramic material is selected from the group consisting of alumina and aluminum nitride.

4. The device of claim 1, wherein said lead members comprise a gate pin, a drain member and a source member.

5. The device of claim 1, wherein the transistor member is a metal oxide semiconductor field effect transistor (MOSFET).

6. The device of claim 1, wherein the transistor member is an isolated gate bipolar transistor (IGBT).

7. The device of claim 1, wherein the first non-conductive substrate member and the second non-conductive substrate member are alumina substrates having a thickness of less than 500 micrometers.

8. The device of claim 1, wherein the first non-conductive substrate member and the second non-conductive substrate member are alumina substrates having a thickness of less than 250 micrometers.

9. The device of claim 1, wherein the ultra-thick thick film material is substantially free of metal oxides.

10. The device of claim 1, wherein the ultra-thick thick film material contains less than 1% metal oxides by weight.

11. The device of claim 1, wherein the first non-conductive substrate member and the second non-conductive substrate member are made of aluminum nitride with conductor thick film buffer layer and the ultra-thick thick film layers secured to the outer surfaces of the first non-conductive substrate member and the second non-conductive substrate member are substantially free of metal oxides.

12. The device of claim 1, wherein the first non-conductive substrate member and the second non-conductive substrate member are made of aluminum nitride and the ultra-thick thick film layers secured to the outer surfaces of the first non-conductive substrate member and the second non-conductive substrate member contains less than 1% metal oxides.

13. The device of claim 1, wherein the first non-conductive substrate member and the second non-conductive substrate member are made of aluminum nitride with conductor buffer layer and the ultra-thick thick film layers secured to the outer surfaces of the first non-conductive substrate member and the second non-conductive substrate member consists essentially of a conductive metal powder and one or more organic resins.
